(19) Europäisches Patentamt / European Patent Office / Office européen des brevets

(11) **EP 3 617 646 B1**

(12) **FASCICULE DE BREVET EUROPEEN**

(45) Date de publication et mention de la délivrance du brevet:
**13.04.2022 Bulletin 2022/15**

(21) Numéro de dépôt: **19194449.5**

(22) Date de dépôt: **29.08.2019**

(51) Classification Internationale des Brevets (IPC):
**G01B 15/08** (2006.01)    **G01N 23/201** (2018.01)
**G03F 7/20** (2006.01)

(52) Classification Coopérative des Brevets (CPC):
**G01N 23/201; G03F 7/70625;** G01N 2223/611

(54) **METHODE DE MESURE DE LA RUGOSITE DE LIGNE D'UN RESEAU DE LIGNES PAR DIFFRACTION DE RAYONS X**

MESSMETHODE DER LINIENRAUHEIT EINES LINIENNETZES DURCH BEUGUNG VON RÖNTGENSTRAHLEN

METHOD FOR MEASURING THE LINE ROUGHNESS OF AN ARRAY OF LINES BY X-RAY DIFFRACTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.08.2018 FR 1857764**

(43) Date de publication de la demande:
**04.03.2020 Bulletin 2020/10**

(73) Titulaires:
- **Commissariat à l'énergie atomique et aux énergies alternatives 75015 Paris (FR)**
- **Université Grenoble Alpes 38400 Saint-Martin-d'Hères (FR)**

(72) Inventeur: **RECHE, Jérôme 38054 GRENOBLE CEDEX 09 (FR)**

(74) Mandataire: **Brevalex 95, rue d'Amsterdam 75378 Paris Cedex 8 (FR)**

(56) Documents cités:
**US-A1- 2004 218 192**

- **FREYCHET G ET AL: "A study of lateral roughness evaluation through critical-dimension small angle x-ray scattering (CD-SAXS)", PROCEEDINGS OF SPIE; [PROCEEDINGS OF SPIE ISSN 0277-786X VOLUME 10524], SPIE, US, vol. 9778, 8 mars 2016 (2016-03-08), pages 97783V-97783V, XP060065365, DOI: 10.1117/12.2235102 ISBN: 978-1-5106-1533-5**
- **RECHE JÉRÔME ET AL: "Programmed LWR metrology by multi-techniques approach", PROCEEDINGS OF SPIE; [PROCEEDINGS OF SPIE ISSN 0277-786X VOLUME 10524], SPIE, US, vol. 10585, 13 mars 2018 (2018-03-13), pages 105850F-105850F, XP060101418, DOI: 10.1117/12.2292169 ISBN: 978-1-5106-1533-5**

## Description

### DOMAINE TECHNIQUE ET ÉTAT DE LA TECHNIQUE ANTÉRIEURE

La présente invention se rapporte à une méthode de mesure de la rugosité de ligne d'un réseau de lignes de taille micrométrique et/ou nanométrique, par exemple mis en oeuvre dans des éléments dans le domaine de la microélectronique, par exemple pour réaliser des transistors, dans le domaine de la photonique, par exemple pour réaliser des guides d'onde, dans le domaine de la métrologie.

Dans le domaine de la microélectronique, des microstructures, par exemple des lignes sont réalisées dans les éléments microélectroniques par exemple par photolithographie et gravure. Les lignes présentent une certaine rugosité que l'on cherche à maîtriser, car elle peut entraîner des pertes de performance et/ou de fiabilité. Il s'agit notamment de la rugosité de ligne, plus particulièrement la rugosité de bord de lignes. On cherche donc à contrôler celle-ci, notamment en réalisant une mesure précise de celle-ci.

On souhaite pouvoir mesurer une rugosité de 0,8 nm avec une résolution de 0,1 nm.

Cette rugosité peut être mesurée de différentes manières.

Une technique utilise un microscope électronique à balayage ou CD-SEM (Critical Dimension Scanning Electron Microscope en terminologie anglo-saxonne). Il offre une résolution de l'ordre du nm du fait du faisceau d'électrons gaussien utilisé, qui a un diamètre de l'ordre du nanomètre, ce qui ne correspond pas aux attentes. De plus le bruit de mesure avec cet équipement limite l'analyse. En outre lorsque l'échantillon à analyser comporte un grand nombre de lignes, cette technique requiert un grand nombre d'images, ce qui est coûteux en temps de prise d'images et en temps de traitement. Cette technique est décrite par exemple dans Bunday, B. D., Bishop, M., Villarrubia, J. S. and Vladar, A. E., "CD-SEM measurement line-edge roughness test patterns for 193-nm lithography," Microlithogr. 2003, 674-688, International Society for Optics and Photonics (2003*).

Une autre technique met en oeuvre un microscope à force atomique mais la prise d'images est encore plus longue qu'avec le microscope CD-SEM et la résolution atteignable est également de l'ordre du nm.

Une autre technique met en oeuvre la diffusion des rayons X aux petits angles. Cette technique utilise uniquement de modèles simulés ou calculatoire, cette technique est longue du fait du nombre important d'itérations nécessaire.

Le document Reche Jérôme et Al : « Programmed LWR metrology by multi-techniques approach » Proceedings of SPIE, SPIE, US, vol. 10585, 13 mars 2018, pages 105850F-105850F, décrit plusieurs méthodes pour évaluer la rugosité LWR.

### EXPOSÉ DE L'INVENTION

C'est par conséquent un but de la présente invention d'offrir une méthode de mesure de la rugosité de ligne, plus particulièrement la rugosité de largeur de ligne ou LWR (Line Width Roughness) permettant d'atteindre une résolution de l'ordre de 0,1 nm et relativement rapide par rapport aux méthodes de l'état de la technique.

Le but énoncé ci-dessus est atteint par une méthode de mesure de la rugosité de largeur de ligne d'un échantillon comportant un réseau de lignes sensiblement parallèles, comportant l'acquisition d'au moins une image de diffraction dans l'espace réciproque du réseau de lignes obtenue par collecte des rayons X diffusés aux petits angles, d'extraction des intensités dans la direction $q_y$ pour une valeur de $q_x$ donné, le calcul de la densité spectrale de puissance de la variation de largeur des lignes du réseau et la détermination de paramètres caractéristiques de la rugosité de largeur de ligne.

Grâce à l'invention, la durée requise pour l'exécution de la méthode est réduite par rapport à celle requise pour les autres méthodes. En effet, une seule image de diffraction peut être suffisante pour mettre en oeuvre la méthode, le temps d'acquisition et de traitement est réduit.

En outre on ne met pas en oeuvre d'étape de modélisation des lignes en trois dimensions et d'itération, ce qui réduit également le temps de traitement. Enfin, en comparaison avec des méthodes mettant en oeuvre une modélisation et une itération, la méthode selon l'invention donne un résultat unique pour la rugosité de largeur de ligne.

En outre, au vue de la longueur d'onde des rayons X utilisés, il est possible d'atteindre une résolution de l'ordre de 0,1 nm.

En d'autres termes, on réalise une analyse directe de l'image des rayons X diffusées aux petits angles en utilisant la densité spectrale de puissance.

De préférence, on se place à $q_x = 0$ afin de ne mesurer que la rugosité de largeur de ligne et non la rugosité de bord de ligne ou LER (Line Edge Roughness).

En variante, on se place à une valeur de $q_x$ correspondant à un point d'extinction du cliché de diffraction.

Dans un exemple de réalisation, on peut prévoir d'utiliser plusieurs clichés de diffraction de différentes lignes du réseau et de faire la moyenne entre les différentes mesures.

La présente invention a alors pour objet une méthode de mesure de la rugosité de largeur de ligne d'un réseau de p lignes d'un échantillon, p étant supérieur ou égal à 2, lesdites lignes ayant une longueur I, comportant :

a) l'acquisition d'au moins un cliché de diffraction par diffraction en transmission de rayons X aux petits angles au moyen d'un faisceau de rayons X couvrant n lignes dudit réseau, n étant supérieur ou égal à 2,
b) mesure, sur le cliché de diffraction, des intensités le long de la direction qy, dans un plan de coupe passant par qx = 0 ou par une valeur de qx correspondant à un point d'extinction,
c) division desdites intensités par n et par I,
d) traçage de la densité spectrale de puissance,
e) détermination à partir de la densité spectrale de puissance de paramètres caractéristiques de la rugosité de largeur de ligne, formant la mesure de la rugosité de largeur de ligne.

De manière très avantageuse, à l'étape b), lorsque l'on se place à une valeur de qx correspondant à un point d'extinction, une compensation du signal est prévue.

Dans un exemple préféré, n est égal à p.

Dans un exemple de réalisation dans lequel l'étape a) comporte l'acquisition de plusieurs clichés de diffraction de lignes différentes, l'étape b) comporte la mesure, sur chaque cliché de diffraction, des intensités le long de la direction qy, dans un plan de coupe passant par qx = 0 ou par qx correspondant à un point d'extinction, et la méthode comporte l'étape de calcul de la moyenne des intensités mesurés préalablement à l'étape d).

De manière avantageuse, lors de l'étape b), seules les intensités pour qy > 0 ou qy < 0 sont mesurées.

Lors de l'étape e), les paramètres suivant sont déterminés :

- la longueur de corrélation $\xi$,
- la déviation standard $\sigma$,
- l'exposant de rugosité a.

Dans un exemple, le réseau de lignes est en surface de l'échantillon ou est enterrée. Par exemple, l'échantillon est un guide d'onde ou un élément microélectronique.

## BRÈVE DESCRIPTION DES DESSINS

La présente invention sera mieux comprise sur la base de la description qui va suivre et des dessins en annexe sur lesquels :

- la figure 1 est une représentation en perspective d'un exemple d'échantillon avec un réseau de lignes dont on veut mesurer la rugosité de largeur de ligne,
- la figure 2 est une vue de côté d'un autre exemple d'échantillon avec un réseau de lignes dont on veut mesurer la rugosité de largeur de ligne,
- la figure 3 est une représentation schématique d'une ligne et de sa dimension critique ou CD (critical dimension), la rugosité de largeur de ligne étant la variation de cette dimension critique le long de la ligne,
- la figure 4 est une représentation schématique d'un exemple de montage permettant l'acquisition de clichés de diffraction,
- la figure 5 est une vue de dessus d'un échantillon muni d'un réseau de lignes dont on va mesurer la rugosité de bord de ligne,
- la figure 6 représente le cliché de diffraction de l'échantillon de la figure 5,
- la figure 7 est une représentation graphique de la densité spectrale de puissance calculée avec la méthode selon l'invention à partir du cliché de la figure 6 et de la densité spectrale de puissance obtenue par la méthode de l'état de la technique mettant en oeuvre un CD-sem, l'unité en abscisse étant $\log(nm^{-1})$ et en ordonnée étant $\log(nm^3)$.

## EXPOSÉ DÉTAILLÉ DE MODES DE RÉALISATION PARTICULIERS

La méthode décrite dans la présente demande permet de mesurer la rugosité de largeur de ligne ou LWR (Line Width Roughness en terminologie anglo-saxonne) d'un réseau de lignes parallèles de dimensions nanométriques. A des fins de simplicité, la rugosité de largeur de ligne sera désignée « rugosité LWR ». Les lignes forment un réseau organisé s'étendant dans un plan.

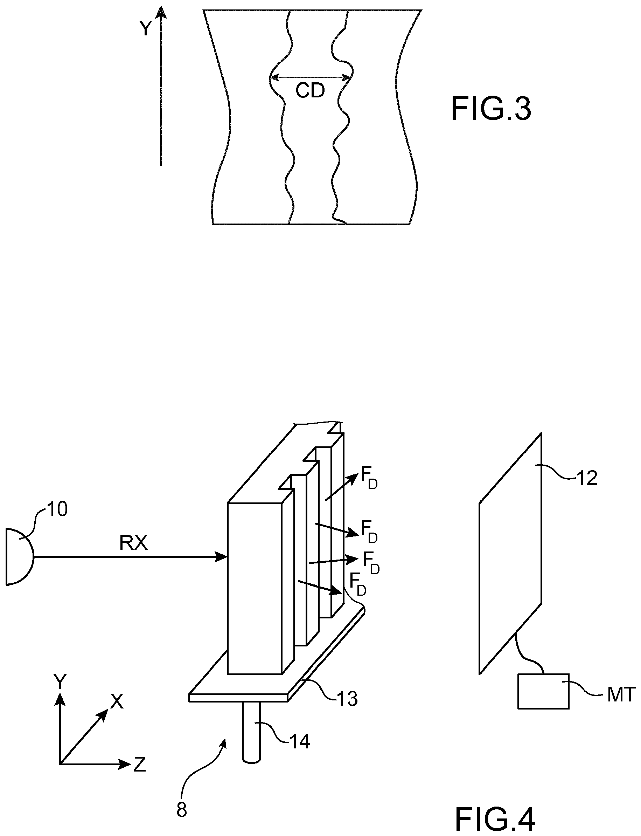

Sur la figure 3, on peut voir une représentation schématique agrandie d'une ligne présentant une rugosité de largeur de ligne. La ligne s'étend selon une direction générale Y La largeur, désignée également dimension critique, entre les deux bords latéraux varie le long de la direction Y. La rugosité de largeur de ligne LWR caractérise cette variation de largeur le long de la ligne. La rugosité de largeur de ligne est définie par des paramètres qui seront décrits ci-dessous.

Dans la description qui va suivre les directions X, Y, Z sont celles de l'espace réel, et les directions qx, qy, qz sont celle de l'espace réciproque. qx est orthogonal à Y et Z, qy est orthogonal à X et Z et qz est orthogonal à X et Y.

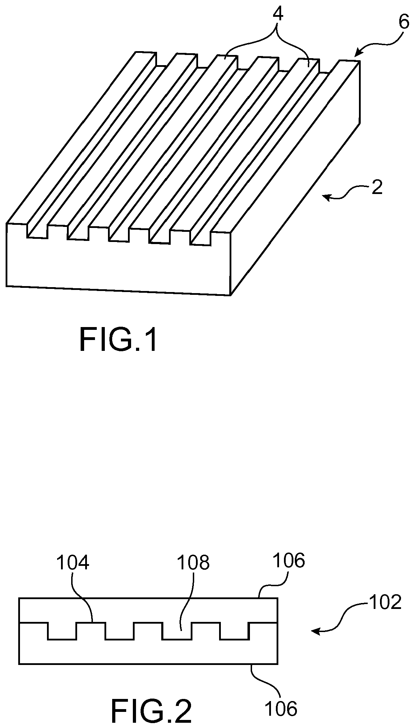

Sur la figure 1, on peut voir un exemple d'un échantillon d'un réseau de lignes dont on souhaite mesurer la rugosité LWR.

L'échantillon 2 comporte un réseau de lignes parallèles 4 formées dans une face 6 de l'échantillon. Les lignes sont séparées par des rainures formant une structure en trois dimensions et elles sont réparties dans le plan du réseau. Dans le cas présenté, il s'agit du plan XY dans l'espace réel ou qx, qy dans l'espace réciproque. Le réseau comporte au moins deux lignes.

Sur la figure 2, on peut voir un autre exemple de réseau de lignes dont la rugosité LWR est mesurable grâce à la méthode selon l'invention. L'échantillon 102 comporte un réseau de lignes 104 ou de rainures parallèles « enterrées », i.e. située entre les deux faces 106 de l'échantillon les lignes étant comblées par un matériau 108. Le réseau comporte au moins deux lignes.

L'échantillon forme par exemple des guides d'onde ou un transistor en microélectronique, notamment la partie active d'un transistor. Le transistor est par exemple un transistor trigate. En variante, les lignes sont les connexions de transistors.

Les lignes peuvent comporter un ou des bords latéraux orthogonaux au fond des lignes et/ou un ou des bords inclinés par rapport à ceux-ci.

Ces exemples ne sont pas limitatifs.

Par exemple, les lignes ont une largeur comprise entre 5 nm et 100 nm, une hauteur comprise entre 20 nm et 200 nm. Par exemple, le réseau peut comporter de deux lignes à une cinquantaine de lignes sur certains niveaux, par exemple pour les mémoires par exemple. Les lignes sont par exemple en silicium, en TiN, en Al, en Ge, en GaAs, en In...

La méthode s'applique à tout réseau de lignes de dimensions nanométriques ou micrométriques.

Le réseau de lignes est généralement réalisé avec les techniques de la microélectronique.

La méthode de mesure de la rugosité LWR comporte :

a) l'acquisition d'au moins une image de diffraction du réseau de lignes dans l'espace réciproque,
b) le traitement de l'image de diffraction pour obtenir la densité spectrale de puissance,
c) détermination de paramètres caractéristiques de la rugosité LWR.

La méthode de détermination de la rugosité de largeur de ligne d'un réseau de lignes ne détermine pas individuellement la rugosité de largeur de chaque ligne, mais acquiert des informations sur toutes les lignes, et divisent ces informations par le nombre de lignes, pour se rapporter à une ligne. Ainsi plus le nombre de lignes sur lesquelles les informations sont acquises est grand, plus la détermination de rugosité de largeur de ligne est précise. On obtient donc une rugosité de largeur de ligne pour le réseau de lignes et non une rugosité de largeur de ligne pour chaque ligne.

Sur la figure 4, on peut voir une représentation schématique d'un exemple de montage permettant l'acquisition d'images de diffraction.

Le montage comporte un porte-échantillon 8 destiné à supporter l'échantillon 2 ou 102, et des moyens d'acquisition de clichés de diffraction. Des moyens de traitement MT des clichés de diffraction. Les moyens de traitement sont mis en oeuvre par un ordinateur.

Les moyens d'acquisition comportent une source de rayons X 10 mettant un faisceau incident selon une direction donnée Z. La source de rayons X est telle qu'elle permet une mesure des rayons X aux petits angles par transmission ou SAXS (Small Angle X-rays Scattering en terminologie anglo-saxonne). Les longueurs d'onde des rayons X sont de préférence comprises entre $10^{-10}$ m à $10^{-12}$m pour disposer de suffisamment d'énergie pour traverser l'échantillon.

Le système comporte un détecteur 12 des rayons X diffusés, le détecteur est de préférence un détecteur bidimensionnel, disposé orthogonalement à la direction Z.

En variante non-revendiquée, une source de flux de neutrons peut être utilisée à la place de la source de rayons X.

Par exemple pour une longueur d'onde de $10^{-12}$m, le faisceau a une énergie de 1240 keV.

A titre d'exemple, un faisceau d'énergie de 17 keV, a un diamètre de 300 $\mu$m de côté et une longueur d'onde de $7,3.10^{-11}$ m.

Le porte-échantillon 8 est disposé entre la source de rayons X 10 et le détecteur 12, et est apte à permettre la mesure de rayons diffusés en mode transmission.

Le porte-échantillon comporte une platine 13 destinée à supporter l'échantillon et un support 14 de platine.

Dans l'exemple représenté, le plan contenant les lignes est orthogonal à la direction du faisceau incident.

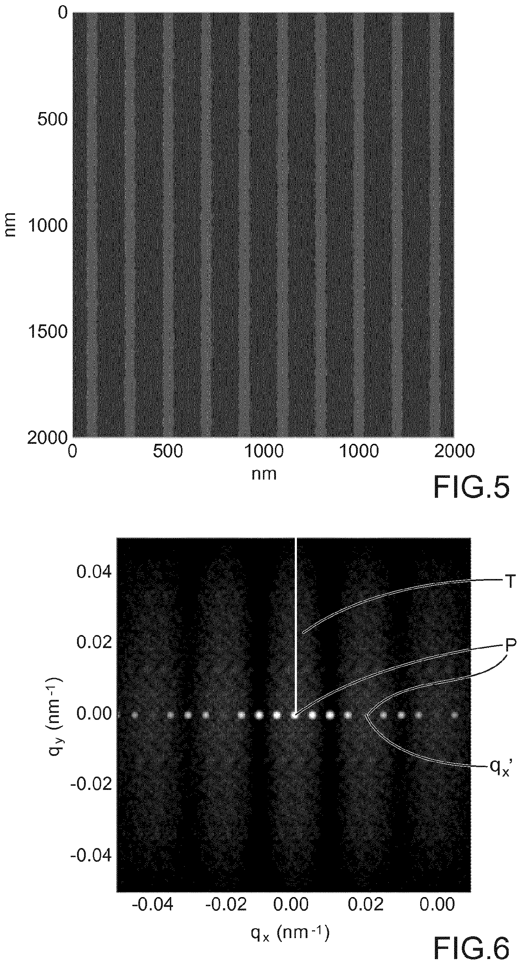

Un exemple de détermination de la rugosité LWR du réseau de lignes représenté sur la figure 5, va maintenant être décrit. L'échantillon comporte un réseau de lignes s'étendant dans les directions X et Y, et mesure 2000 nm de côté.

Lors de l'étape a), l'échantillon est monté sur le porte-échantillon et la source de rayons X est allumée, le diamètre du faisceau de rayons X est tel qu'il éclaire tout ou partie du réseau de lignes. De préférence, plus le nombre de lignes couvert par le réseau est grand, plus les mesures obtenues seront représentatives de la rugosité LWR de toutes les lignes. De préférence, le diamètre du faisceau de rayons X est tel que la surface du faisceau couvre tout le réseau.

On réalise une mesure des rayons X aux petits angles par transmission. Les rayons X sont en partie diffusés par les fonds des lignes et en partie diffusées par les bords de lignes comme cela est symbolisé par les flèches $F_D$. L'acquisition de clichés de diffraction par rayons X aux petits angles par transmission est par exemple décrite dans le document A study of lateral roughness evaluation through critical-dimension small angle x-ray scattering (CD-SAXS)" - G. Freychet et al., chapitres 3 et 4.

Les rayons diffusés sont collectés par le détecteur.

On obtient alors le cliché de diffraction de la figure 6 du réseau de lignes dans l'espace réciproque (qx, qy, qz).

Les points P représentent la répétition de lignes et leurs dimensions moyennes dans l'espace réciproque, et les tâches T autour des points correspondent à la rugosité de bord de ligne, et sont dues aux rayons diffusés par la rugosité des bords de lignes.

Le cliché de diffraction s'étend dans les directions qx et qy, les unités le long de ces axes sont des $nm^{-1}$.

Lors de l'étape b), les informations fournies par le cliché de diffraction sont traitées.

Le point qx = 0, qy = 0 est situé au centre du cliché de diffraction.

Les informations fournies pour qy > 0 et qy <0 sont identiques. On peut donc se contenter de traiter les informations pour qy >0 ou qy < 0.

De même, les informations fournies pour qx > 0 et qx <0 sont identiques. On peut donc se contenter donc de traiter les informations pour qx >0 ou qx < 0.

De préférence, on utilise les informations le long de l'axe qy à qx = 0, qui correspond à une coupe suivant l'axe d'alignement des lignes au point centré sur le faisceau incident.

Les informations à qx = 0 permettent d'obtenir directement la densité spectrale de puissance relative à la rugosité LWR.

Les intensités mesurées le long de l'axe qy correspondent à l'équivalent de la valeur absolue de la transformée de Fourier au carré.

Les intensités mesurées contiennent les informations sur toutes les lignes éclairées par le faisceau de rayons X et sur toute la longueur des lignes. On suppose que les p lignes du réseau de la figure 5 sont éclairées par le faisceau de rayons X.

On divise alors les intensités mesurées par le nombre de lignes éclairées, dans le cas présent p, on obtient les intensités relatives à une ligne et on divise également par la longueur de ligne, i.e. la hauteur de l'image du réseau de la figure 5 pour se ramener à la définition de la densité spectrale de puissance, c'est-à-dire l'intensité obtenue, correspondant à la densité spectrale de puissance D et l'axe qy correspondant à kn.

Il s'agit d'une extraction et d'une transformation des données pour déterminer la densité spectrale de puissance à partir des intensités mesurées sur le cliché de diffraction.

On obtient alors la densité spectrale de puissance des variations de largeur des lignes, ce qui correspond à la rugosité LWR.

A titre d'exemple, on considère le réseau de lignes de la figure 5 qui comporte 10 lignes de longueur de 2000 nm (direction Y).

Les valeurs d'intensité mesurée sur le cliché de la figure 6 sont donc divisées par 10 et par 2000.

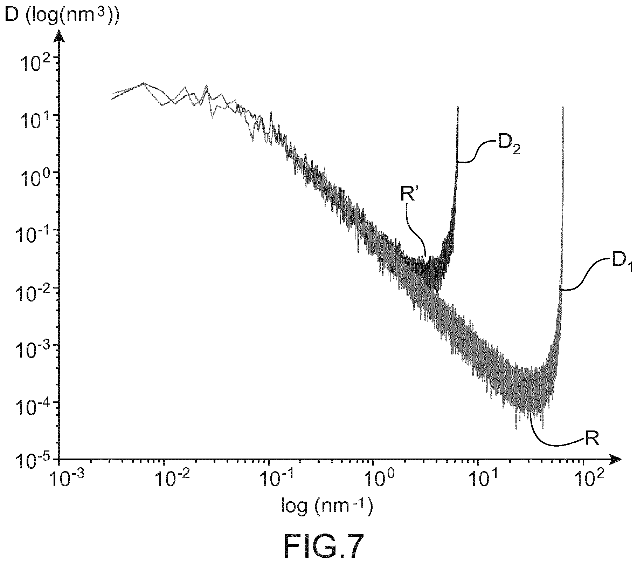

On obtient alors la densité spectrale de puissance D1 représentée sur la figure 7, en $log(nm^3)$ en fonction du log de qy en $nm^{-1}$. Le palier R est repoussé, ce qui permet d'atteindre une résolution de l'ordre de 0,1 nm.

A titre de comparaison est représentée la densité spectrale de puissance D2 obtenue pour le même réseau avec une méthode de l'état de la technique mettant en oeuvre un microscope électronique à balayage. On constate que le palier R' fixe la résolution à environ 1 nm.

La densité spectrale de puissance est une représentation en fréquence spatiale de l'amplitude de la rugosité. Le traitement de la variation de celle-ci permet d'obtenir l'information de la rugosité sur toute la longueur des lignes.

A partir de la densité spectrale de puissance, des paramètres caractéristiques de la rugosité LWR sont déterminés

- La longueur de corrélation $\xi$,
- La déviation standard $\sigma$,
- L'exposant de rugosité a.

Ces paramètres sont bien connus de l'homme du métier et sont par exemple décrits dans *Unbiased line width roughness measurements with critical dimension scanning electron microscopy and critical dimension atomic force*

*microscopy,* L. Azarnouche, E. Pargon, K. Menguelti, M. Fouchier, D. Fuard et al. in Journal of Applied Physics 111, 084318 (2012) - April 2012.

La détermination de ces paramètres est réalisée en utilisant un modèle mathématique de la courbe de densité spectrale de puissance intégrant ces paramètres, et en modifiant les valeurs de ces paramètres pour se rapprocher de la courbe de densité spectrale de puissance obtenue précédemment. Cette détermination est faite au moyen d'un logiciel tel qu'Excel® ou un code python ou r-code.

Le modèle est par exemple

$$P_n = \frac{\Delta y}{2\pi N}\sigma^2 \left[ \sum_{m=0}^{N-1}(2 - \delta_m)\, e^{-\left|\frac{m\Delta y}{\xi}\right|^{2\alpha}} cos(k_n m\Delta y)\, (N - m) \right]$$

avec N le nombre de point, Δy l'écart entre les points et kn le nombre d'onde ou fréquence spatiale.

Le réseau de lignes de la figure 6 a été obtenu par simulation en fixant les paramètres ξ, α, σ, ave ξ = 50 nm, α = 0,5 et σ = 5 nm.

En utilisant la méthode selon l'invention, on obtient à partir de la densité spectrale de puissance de la figure 7 ave ξ = 50,1 nm, α = 0,5 et σ = 5,7 nm.

Il apparaît donc que la méthode selon l'invention permet de mesurer de manière relativement précise la rugosité LWR d'un réseau de lignes.

Selon une variante avantageuse, on peut prévoir d'acquérir plusieurs clichés de diffraction de lignes différentes, et de moyenner les mesures obtenues. Le calcul des moyennes est réalisé avant l'étape de détermination des paramètres.

Cette méthode est plus longue que celle n'utilisant qu'un seul cliché, mais est reste sensiblement plus courte que les méthodes de l'état de la technique

En variante, on peut choisir de se placer à une coupe autre que qx = 0. On choisit de préférence une coupe au niveau d'un point d'extinction, par exemple à qx' représenté sur la figure 6. Il est à noter qu'à qx ≠ 0 les intensités mesurées sont plus faibles, il est alors préférable de compenser cette baisse d'intensité, par exemple par une normalisation, en prenant en compte le facteur de forme, c'est-à-dire la taille moyenne des lignes ainsi que leur pas de répétition, qui induisent cette diminution d'intensité suivant qx, comme cela est par exemple décrit dans A study of lateral roughness evaluation through critical-dimension small angle x-ray scattering (CD-SAXS)" de G. Freychet et al., chapitre 4.

Grâce à l'invention, la rugosité LWR peut être mesurée avec une résolution au moins de l'ordre de 0,1 nm et de manière rapide, car un seul cliché de diffraction peut être utilisé. On peut envisager d'atteindre des résolutions supérieures, en effet la résolution dépend de la résolution du faisceau de rayons X qui peut atteindre $10^{-2}$ nm, voire $10^{-3}$ nm. La méthode de mesure de la rugosité de largeur de ligne selon l'invention peut offrir une résolution $10^{-2}$ nm, voire $10^{-3}$ nm.

L'échantillon représenté sur la figure 2 comporte des lignes 104 et des rainures 108. En retournant l'échantillon, la référence 104 désigne des rainures et 108 des lignes. La méthode selon l'invention permet de mesurer la rugosité LWR des lignes 104 et des rainures 108. Les signaux sur les clichés de diffraction correspondent au matériau le plus dense du point de vue électronique. Par déduction, on peut déterminer la rugosité LWR des lignes ou rainures en matériau moins dense.

## Revendications

1. Méthode de mesure de la rugosité de largeur de ligne d'un réseau de p lignes (4, 104) d'un échantillon (2, 102), p étant supérieur ou égal à 2, les lignes du réseau s'étendant selon une direction générale Y, les directions X, Y, Z étant les directions de l'espace réel, lesdites lignes ayant une longueur l, comportant :

   a) l'acquisition d'au moins un cliché de diffraction par diffraction en transmission de rayons X aux petits angles au moyen d'un faisceau de rayons X couvrant n lignes dudit réseau, n étant supérieur ou égal à 2,
   b) mesure, sur le cliché de diffraction, des intensités le long de la direction qy, dans un plan de coupe passant par qx = 0 ou par une valeur de qx correspondant à un point d'extinction, les directions qx, qy, qz étant les directions de l'espace réciproque,
   c) division desdites intensités par n et par l,
   d) traçage de la densité spectrale de puissance (D1) à partir des valeurs obtenus à l'étape c),
   e) détermination à partir de la densité spectrale de puissance de paramètres caractéristiques de la rugosité de largeur de ligne, formant la mesure de la rugosité de largeur de ligne, lesdits paramètres caractéristiques étant :

- la longueur de corrélation $\xi$,
- la déviation standard $\sigma$,
- l'exposant de rugosité a.

2. Méthode de mesure de la rugosité de largeur de ligne selon la revendication 1, dans laquelle à l'étape b), lorsque l'on se place à une valeur de qx correspondant à un point d'extinction, une compensation des intensités est prévue.

3. Méthode de mesure de la rugosité de largeur de ligne selon la revendication 1 ou 2, dans laquelle n est égal à p.

4. Méthode de mesure de la rugosité de largeur de ligne selon l'une des revendications 1 à 3, dans laquelle l'étape a) comporte l'acquisition de plusieurs clichés de diffraction de lignes différentes, l'étape b) comporte la mesure, sur chaque cliché de diffraction, des intensités le long de la direction qy, dans un plan de coupe passant par qx = 0 ou par qx correspondant à un point d'extinction, et dans laquelle la méthode comporte l'étape de calcul de la moyenne des intensités mesurés préalablement à l'étape d).

5. Méthode de mesure de la rugosité de largeur de ligne selon l'une des revendications 1 à 4 dans laquelle, lors de l'étape b), seules les intensités pour qy > 0 ou qy < 0 sont mesurées.

6. Méthode de mesure de la rugosité de largeur de ligne selon l'une des revendications 1 à 5, dans laquelle, le réseau de lignes est en surface de l'échantillon ou est enterrée.

7. Méthode de mesure de la rugosité de largeur de ligne selon l'une des revendications 1 à 6, dans laquelle l'échantillon est un guide d'onde.

8. Méthode de mesure de la rugosité de largeur de ligne selon l'une des revendications 1 à 6, dans laquelle l'échantillon est un élément microélectronique.

**Patentansprüche**

1. Verfahren zur Messung der Linienbreitenrauhigkeit eines Netzes von p Linien (4, 104) einer Probe (2, 102), wobei p größer oder gleich 2 ist, sich die Linien des Netzes in einer allgemeinen Richtung Y erstrecken, die Richtungen X, Y, Z die realen Raumrichtungen sind und die Linien eine Länge I haben, umfassend:

    a) Erfassen wenigstens eines Beugungsmusters durch Röntgenkleinwinkel-Transmissionsbeugung mittels eines Röntgenstrahls, der n Linien des Gitters abdeckt, wobei n größer oder gleich 2 ist,
    b) Messen der Intensitäten auf dem Beugungsmuster entlang der qy-Richtung in einer Schnittebene durch qx = 0 oder durch einen Wert von qx, der einem Extinktionspunkt entspricht, wobei die Richtungen qx, qy, qz die Richtungen des reziproken Raums sind,
    c) Division der genannten Intensitäten durch n und I,
    d) Zeichnen der spektralen Leistungsdichte (D1) aus den in Schritt c) erhaltenen Werten,
    e) Bestimmen von charakteristischen Parametern der Linienbreitenrauhigkeit, die das Maß der Linienbreitenrauhigkeit bilden, aus der spektralen Leistungsdichte, wobei die charakteristischen Parameter sind:

        - die Korrelationslänge $\xi$,
        - die Standardabweichung $\sigma$,
        - der Rauhigkeitsexponent $\alpha$.

2. Verfahren zur Messung der Linienbreitenrauhigkeit nach Anspruch 1, wobei in Schritt b) bei einem Wert von qx, der einem Extinktionspunkt entspricht, eine Intensitätskompensation vorgesehen ist.

3. Verfahren zur Messung der Linienbreitenrauhigkeit nach Anspruch 1 oder 2, wobei n gleich p ist.

4. Verfahren zur Messung der Linienbreitenrauhigkeit nach einem der Ansprüche 1 bis 3, wobei Schritt a) den Erhalt mehrerer Beugungsmuster von verschiedenen Linien umfasst, Schritt b) auf jedem Beugungsbild das Messen der Intensitäten entlang der qy-Richtung in einer Schnittebene durch qx = 0 oder durch qx, die einem Extinktionspunkt entspricht, umfasst und wobei die Methode den Schritt der Berechnung des Mittelwerts der zuvor in Schritt d) gemessenen Intensitäten umfasst.

5. Verfahren zur Messung der Linienbreitenrauhigkeit nach einem der Ansprüche 1 bis 4, wobei in Schritt b) nur die Intensitäten für qy > 0 oder qy < 0 gemessen werden.

6. Verfahren zur Messung der Linienbreitenrauhigkeit nach einem der Ansprüche 1 bis 5, wobei das Liniennetz auf der Oberfläche der Probe liegt oder unterirdisch verlegt ist.

7. Verfahren zur Messung der Linienbreitenrauhigkeit nach einem der Ansprüche 1 bis 6, wobei die Probe ein Wellenleiter ist.

8. Verfahren zur Messung der Linienbreitenrauhigkeit nach einem der Ansprüche 1 bis 6, wobei die Probe ein mikroelektronisches Element ist.

**Claims**

1. A method for measuring the line width roughness of an array of p lines (4, 104) of a sample (2, 102), p being greater than or equal to 2, the lines of the array extending according to a general direction Y, the directions X, Y, Z being the directions of the real space, said lines having a length l, comprising:

   a) acquiring at least one diffraction photo by transmission diffraction of X-rays at small angles by means of an X-ray beam covering n lines of said array, n being greater than or equal to 2,
   b) measuring, on the diffraction photo, the intensities along the direction qy, in a sectional plane passing through qx=0 or through a value of qx corresponding to an extinction point, the directions qx, qy, qz being the directions of the reciprocal space,
   c) dividing said intensities by n and by l,
   d) plotting the power spectral density (D1) from the values obtained at step c),
   e) determining from the power spectral density of characteristic parameters of the line width roughness, forming the measurement of the line width roughness, said characteristic parameters being:

   - the correlation length $\xi$,
   - the standard deviation $\sigma$,
   - the roughness exponent $\alpha$.

2. The method for measuring the line width roughness according to claim 1, wherein at step b), when considering a value of qx corresponding to an extinction point, a compensation of the intensities is provided for.

3. The method for measuring the line width roughness according to claim 1 or 2, wherein n is equal to p.

4. The method for measuring the line width roughness according to one of claims 1 to 3, wherein step a) includes acquiring several diffraction photos of different lines, step b) includes measuring, on each diffraction photo, intensities along the qy direction, in a sectional plane passing through qx=0 or through qx corresponding to an extinction point, and wherein the method includes the step of computing the average of the intensities measured prior to step d).

5. The method for measuring the line width roughness according to one of claims 1 to 4, wherein, during step b), only the intensities for qy>0 or qy<0 are measured.

6. The method for measuring the line width roughness according to one of claims 1 to 5, wherein the array of lines is at the surface of the sample or is buried.

7. The method for measuring the line width roughness according to one of claims 1 to 6, wherein the sample is a waveguide.

8. The method for measuring the line width roughness according to one of claims 1 to 6, wherein the sample is a microelectronic element.

4   6

2

## FIG.1

104   108   106

102

106

## FIG.2

FIG.3

FIG.4

FIG.5

FIG.6

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- CD-SEM measurement line-edge roughness test patterns for 193-nm lithography. **BUNDAY, B. D. ; BISHOP, M. ; VILLARRUBIA, J. S. ; VLADAR, A. E.** Microlithogr. International Society for Optics and Photonics, 2003, vol. 2003, 674-688
- **RECHE JÉRÔME et al.** Programmed LWR metrology by multi-techniques approach. *Proceedings of SPIE, SPIE, US,* 13 Mars 2018, vol. 10585, 105850F-105850F

- **G. FREYCHET et al.** A study of lateral roughness evaluation through critical-dimension small angle x-ray scattering (CD-SAXS)
- **L. AZARNOUCHE ; E. PARGON ; K. MENGUELTI ; M. FOUCHIER ; D. FUARD et al.** *Journal of Applied Physics,* Avril 2012, vol. 111, 084318